Europäisches Patentamt

**European Patent Office** (11) Publication number: **0 020 746**

Office européen des brevets **B1**

(12) **EUROPEAN PATENT SPECIFICATION**

(45) Date of publication of patent specification: **04.05.83**

(21) Application number: **80900181.1**

(22) Date of filing: **27.12.79**

(86) International application number:
**PCT/US79/01127**

(87) International publication number:
**WO 80/01363 10.07.80 Gazette 80/15**

(51) Int. Cl.³: **B 08 B 7/00, B 08 B 9/00, H 01 J 17/22**

(54) **PROCESS AND APPARATUS FOR CLEANING WALL DEPOSITS FROM A FILM DEPOSITION FURNACE TUBE.**

(30) Priority: **29.12.78 US 974415**

(43) Date of publication of application:
**07.01.81 Bulletin 81/1**

(45) Publication of the grant of the patent:
**04.05.83 Bulletin 83/18**

(84) Designated Contracting States:
**DE GB NL**

(56) References cited:
**US - A - 3 615 956**
**US - A - 3 652 324**
**US - A - 3 795 557**
**US - A - 3 867 216**
**US - A - 3 971 684**
**US - A - 4 065 369**
**US - A - 4 123 316**
**US - A - 4 123 663**
**US - A - 4 138 306**
**US - A - 4 151 034**
**US - A - 4 158 589**
**US - A - 4 160 690**

(73) Proprietor: **NCR Corporation**
**World Headquarters**
**Dayton Ohio 45479 (US)**

(72) Inventor: **ROMANO-MORAN, Roberto**
**9775 Pawnee Pass**
**Centerville OH 45459 (US)**

(74) Representative: **Robinson, Robert George (GB)**
**International Patent Dept., NCR Ltd. 206**
**Marylebone Road**
**GB-London NW1 6LY (GB)**

Process and apparatus for cleaning wall deposits from a film deposition furnace tube

Technical field

The invention relates to the cleaning of deposition systems and, more particularly, to cleaning furnace tubes used for chemical vapor deposition of films such as silicon (both polycrystalline and monocrystalline), silicon oxide and silicon nitride.

Background art

Silicon, silicon oxide and silicon nitride films are widely used in miroelectronics technology. Their deposition can be by any one of a number of processes including plasma deposition, chemical vapor deposition, etc. Low pressure, chemical vapor deposition (LPCVD) using large-tube furnaces combines the deposition control and quality which is characteristic of CVD processes with the ability to process large wafer loads. However, it is typical that after even a few deposition cycles, the interior wall(s) of the furnace tube becomes (become) coated with the film constituents and other contaminants. The result is flaking of the deposit or cracking of the tube due to the different thermal expansions of the tube material, usually quartz, and the deposit. Furthermore, in depositing silicon nitride, a powder is frequently deposited in the cooler regions of the tube such as at the loading door at the entrance to the tube. Deposits such as these are a source of particulates which alter the deposition rate and contaminate the deposited film, and cause defects in the form of pinholes, granular surface regions, etc.

Because of the above problems and to avoid low yields during semiconductor device fabrication, the furnace tube must be cleaned periodically. Cleaning typically involves allowing the tube to cool; removing the tube from the furnace; cleaning the tube by etching for several hours in a wet bath containing, e.g., a 1:1 ratio by volume of concentrated hydrofluoric and nitric acids; rinsing the tube in water; replacing the tube; and resetting the deposition temperature cycle, which is perturbed when the tube is removed. After replacing the tube, the furnace is heated to 100°C or higher to vaporize any remaining water. This cleaning process is time-consuming and involves the risks of tube breakage and handling corrosive cleaning materials.

Plasma furnaces or CVD reactor furnaces have been used to perform different operations in the reactor by altering the reactor atmosphere. For example, U.S. 3,940,506 issued February 24, 1976 to Heinecke teaches etching silicon dioxide or depositing a polymer by controlling the concentration of reducing species, such as hydrogen, in a plasma etchant which contains fluorine and carbon. U.S. 3,867,216 issued February 18, 1975 to Jacob teaches etching oxide or nitride without degrading a photoresist mask, and then stripping the mask, by varying the oxygen ratio in a plasma-forming binary mixture of oxygen and halocarbon.

Furthermore, etching and deposition of the same material in the same apparatus is known. U.S. 3,945,846 issued March 23, 1976 to Goldsmith et al uses the same reactor furnace to etch silicon and hydrochloric acid, then deposit epitaxial silicon by the reduction of dichlorosilane, both at 1,050°C. to 1,200°C. U.S. 3,914,127 issued October 21, 1975 to Buss et al teaches the use of a plasma reactor to perform several of the steps of fabricating a CCD device, including sequentially etching an oxide or nitride film in a plasma-containing carbon tetrafluoride at less than 150°C, then depositing oxide or nitride from a plasma at 200°C to 400°C.

Thus, in situ cleaning of wafers has been done in small deposition systems and in small plasma reactors. Here, the addition of plasma cleaning capability has been relatively straightforward because of the small size of such systems and because the systems are built with the facility for plasma operation.

Disclosure of the invention

It is an object of the invention to use plasma techniques for cleaning in situ large furnace tubes used in low pressure chemical vapor film deposition systems.

Thus, according to the invention, there is provided a process for cleaning wall deposits from a furnace tube used in a film deposition furnace system, the tube having a gas inlet end and a gas exit end, the improvement wherein the tube is cleaned in situ in the furnace, comprising: maintaining the tube interior at subatmospheric pressure; supplying gas to the gas inlet end of the tube, the gas being suitable for creating a deposit-etching plasma; generating RF energy; and applying the RF energy to RF element means located along a selected portion of the tube adjacent the gas inlet end for coupling the RF energy to the gas to form a deposit-etching plasma over at least the selected portion of the tube.

It should be clear that the cleaning of a furnace tube without its removal from the furnace reduces operating time and costs and increases safety of operation. Also, the use of plasma cleaning is advantageous, since plasma is economical, low in contaminants, non-toxic and non-corrosive. The invention may be used to clean dielectric films such as silicon oxide and silicon nitride, conductor films, and semiconductor films such as silicon. The cleaning plasma can be extended outside the selected portion of the tube occupied by the RF element by decreasing the reactant flow rate, decreasing the pressure, and/or varying the power.

## Brief description of the drawing

One embodiment of the invention will now be described, by way of example, with reference to the accompanying drawings in which:

Figs. 1—4 are schematic representations of alternative embodiments of LPCVD systems which have in situ, plasma self-cleaning capability.

Fig. 5 is a cross-sectional representation of the furnace tube used in practicing the invention, showing zone dimensions and means for applying an electric field to the furnace tube.

## Best mode for carrying out the invention

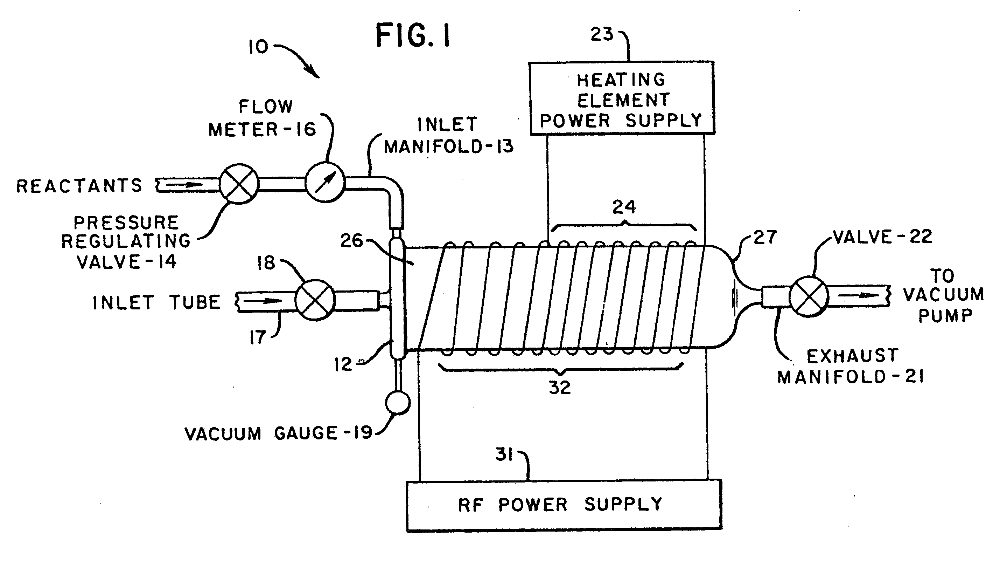

Fig. 1 is a schematic illustration of one embodiment of apparatus 10 for both depositing films such as silicon nitride using LPCVD, and also for cleaning the furnace tube(s) in which deposition takes place, in situ, using a plasma etch.

The apparatus 10 comprises an LPCVD furnace system including a tube 11, typically made of fused quartz, having a cover 12 at the inlet end 26 of the tube and a gas inlet manifold 13. Gaseous reactants are admitted to the tube 11 via the inlet manifold 13 and flow rates are controlled by a pressure-regulating valve 14 and read from a flow meter 16, both of which are connected to the inlet manifold. Gas inlet 17, which is opened and closed by valve 18, connects the interior of the tube 11 to a source of inert gas, such as nitrogen. Vacuum gauge 19 is connected to the interior of the tube adjacent the inlet end 26 for providing readings of the internal pressure.

The opposite, exhaust end 27 of the tube is connected to an exhaust manifold 21, to which is connected a gate valve 22 for controlling the connection of the tube 11 to a vacuum pump (not shown). The path of movement of gases along the tube is from the inlet end 26 to the exhaust end 27. The terms "downstream" or "upstream" refer to this flow.

A power supply 23 provides current to electric resistance heating coils 24 for heating the internal volume of the tube 11 and for pyrolytically depositing silicon, silicon nitride, silicon oxide or other films from the reactants entering via inlet manifold 13.

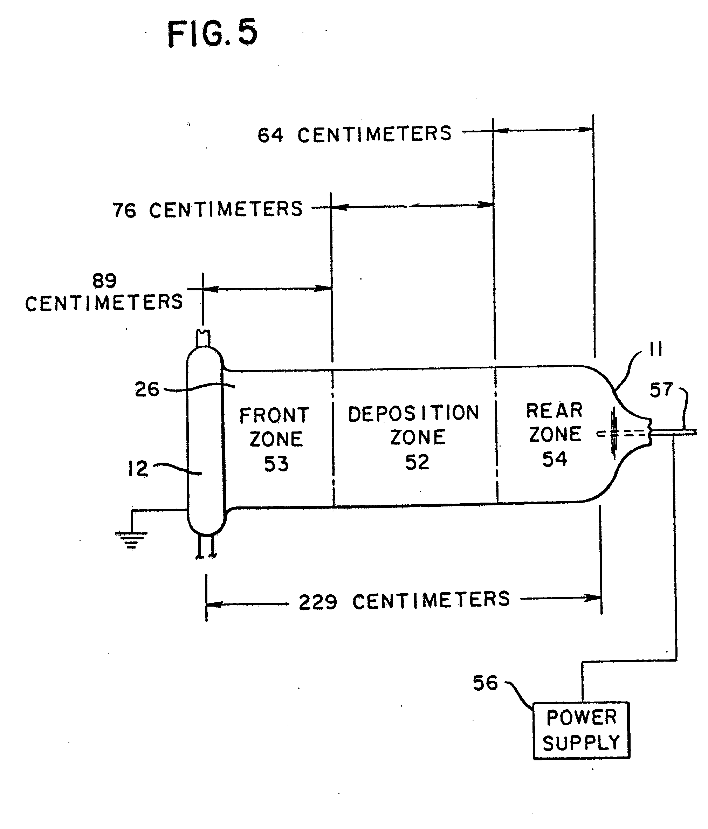

An example of a furnace system which employs the type of arrangement shown in Fig. 1 is the model 4000S-72.00, available from Thermco Products Corp., 1465 No. Batavia St., Orange, California 92668. This furnace system contains four interchangeable furnace tubes 11, which are supplied, heated and evacuated as shown in Fig. 1. The tubes typically are about 229 centimeters long and about 13.5 centimeters in diameter. Each tube can hold approximately 120 10.2 centimeters diameter wafers. The heating rods 24 span approximately the 178—191 centimeters of tube length adjacent the exit end 27. This length is sufficient to provide reproducible deposition along the length of the deposition zone. Referring to Fig. 5, deposition zone 52 is an approximately 76 centimeter long central region having a closely controlled temperature profile. The deposition zone is flanked by cooler, front and rear zones 53 and 54.

Referring to Fig. 1, in accordance with this invention, an RF plasma-generating element (or elements) is (are) provided along a selected length of the tube to provide a plasma for cleaning the aforementioned deposit from at least the selected length. In the embodiment of the invention shown in Fig. 1, RF energy is supplied by a power supply 31 and the RF energy is coupled to the tube 11 by an RF element in the form of an induction coil 32 which surrounds the tube and extends along substantially the length of the tube. The RF energy generates an etching plasma when suitable reactants, typically a halocarbon and an oxidant, are admitted via inlet manifold 13. The reactant gas, reactant gas flow rate, RF power, and internal pressure control the removal rate or etch rate provided by the plasma. For example, the type of reactant gas (gases) can be selected— such as by selecting the type of halocarbon (freon) and the ratio of halocarbon to oxygen— to provide the optimum etch rates for different films. Although all experimentation has been done at a temperature of about 750°C and thus, no data has been taken as to the effect of temperature on etching, etching rate and cleaning are increased as the temperature is increased.

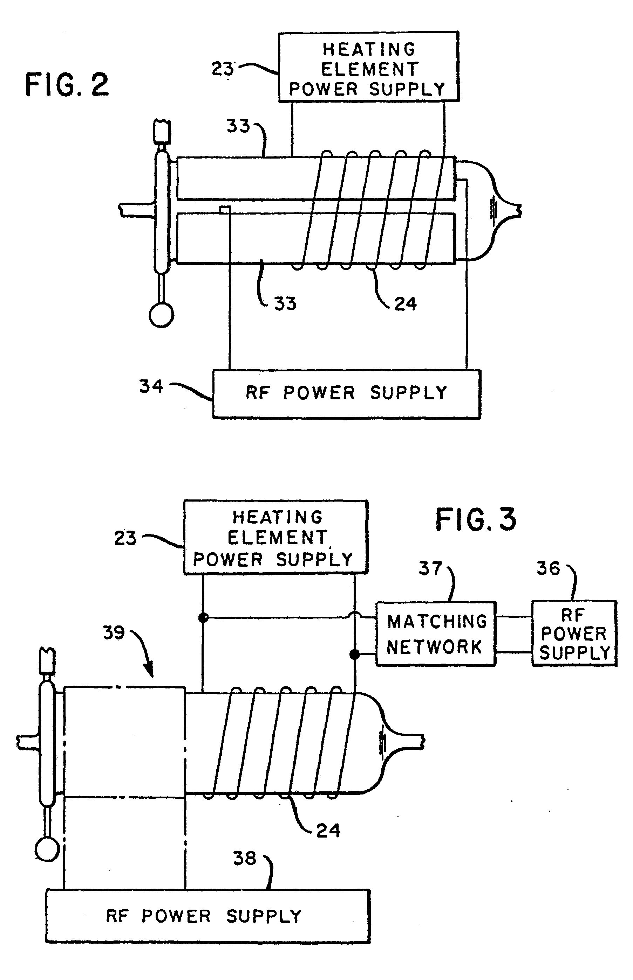

The RF heating element is not limited to an induction coil 32. In another embodiment, shown in Fig. 2, the RF heating element is a pair of capacitor plates 33—33 which capacitively couple RF power from supply 34 to the tube 11. The plates 33—33 can be of platinum or tungsten or other high-melting point material which is plated, painted or otherwise applied to the tube 11. Alternatively, plates 33—33 can be mounted about the outside of the tube. The plate area can be varied along the length of the tube 11 to vary the RF power profile along the tube. Capacitive coupling is thought (1) to be accompanied by higher temperatures than is inductive coupling and (2) to create more collisions with the tube walls than does inductive coupling. Both features should provide enhanced cleaning ability.

In still another embodiment of the invention, plasma-creating energy can be applied to the portion of the furnace tube 11 encompassed by the RF coupling element 24 by coupling the RF power directly to the element. As shown in Fig. 3, RF power supply 36 is coupled to the heating element 24 by matching network 37. A separate RF power supply 38 is coupled to RF element 39, which may be a coil (similar to coil 32 of Fig. 1) or capacitive plates (similar to plates 33—33 of Fig. 2), to clean the portion of the tube in front of heating element 24.

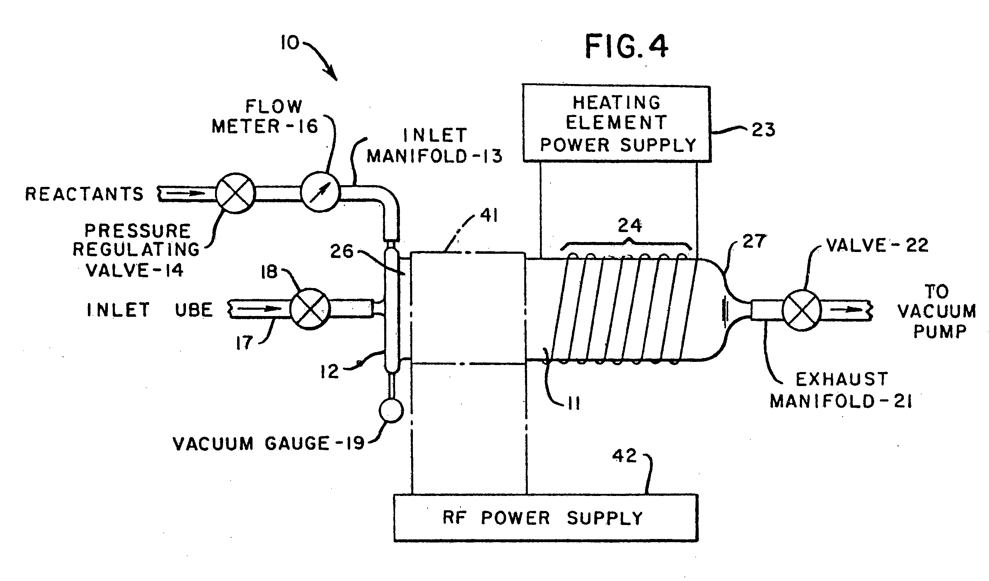

An important feature of the invention arises from the dicovery that the RF coupling element (coil, plates, etc.) need not span the entire length of the tube in order to clean along the entire length of the tube. Indeed, plasma techniques can be used to clean the entire tube, even if a partial-length RF coupling element encompasses substantially less than the tube length. To accomplish this, and referring to Fig. 4, the partial-length RF coupling element 41 is positioned adjacent the front end 26 of the tube. Then, by controlling the etch parameters, the plasma generated by element 41 and power supply 42 can be extended toward the rear 27 of the tube.

Alternatively, or in addition to the embodiments of Figs. 1—4, a DC or AC electric field could be applied by power supply 56 between the grounded door 12 and an electrode 57 inserted in the tube 11 through the exhaust manifold 21. See Fig. 5. By this means the charged particles can be accelerated towards the deposition zone by the appropriate selection of flow pressure and applied voltage. The accelerated particles will in turn produce the more active species necessary to etch or aid in etching the walls of the tube. This arrangement would be particularly helpful in etching the rear zone.

It should be noted that the partial-length RF coupling element 41 is upstream relative to the flow of reactants through the tube 11 in order for the plasma to be extended. That is, positioning the partial-length RF element 41 downstream, proximate the exit end or rear 27 of the tube, would make cleaning the front of the tube more difficult, for the plasma cannot be easily extended upstream.

The following examples utilize the apparatus of Fig. 4.

Example 1

In one illustration of numerous choices of deposition procedure, the tube 11 was preheated to between 700—850°C, and as many as 120 wafers were placed in the approximately 76 centimeter long deposition zone 52 (Fig. 5). The cover 12 was then attached, gas inlet tube 17 was closed, and the vacuum pump was used to evacuate the interior of the tube to a pressure of about one micron of mercury. Ammonia ($NH_3$) was then supplied to the interior of the tube via inlet manifold 13 at a flow rate of between 50—100 sccpm (standard cubic centimeters per minute). Dichlorosilane gas, $SiH_2Cl_2$ (DCS), was then added at a flow rate of 10—30 sccpm to the ammonia flow to deposit silicon nitride on the partially-processed wafers. Using a furnace tube that had been cleaned using the above-described wet bath etch, these exemplary temperature, flow rate and internal pressure parameters provided an initial silicon nitride deposition rate of about 10 to 50 Angstroms per minute (.001 to .005 microns).

After deposition was complete, the DCS and the ammonia flow were terminated and the pressure was pumped down to about one micron. Then, nitrogen was applied under pressure via the inlet 17 to break the vacuum and permit removal of the wafers.

The above deposition cycle was employed a number of times, each to form 500 Angstrom-thick (0.05 microns thick) silicon nitride films on silicon substrates. The initial deposition rate (using a furnace tube which had been cleaned using the above-described wet, hydrofluoric acid:nitride acid etch) was 19 Angstroms (.0019 microns) per minute. After the numerous deposition cycles, the tube walls were covered by a silicon nitride-containing deposit that was believed to be about 12,000 Angstroms (1.2 microns) thick. This thick deposit (indeed even the much thinner deposit resulting from only a few deposition cycles) is characterized by a change in deposition rate from the 19 Angstroms (.0019 microns) per minute rate (for the clean tube) to 24 Angstroms (.0024 microns) per minute.

The RF plasma arrangement of Fig. 4 was then applied in an attempt to clean the silicon nitride deposit. The RF coil 41 occupied about 25 cm at the front of the approximately 89 centimeter long front zone 53. As mentioned previously and illustrated in Fig. 5, the Thermco furnace provides an approximately 76 cm long, controlled-temperature deposition zone 52 which is flanked by the cooler, 89 centimeter long front zone 53 and 64 centimeter long rear zone 54. For optimum uniformity of thickness and characteristics, wafer film deposition is confined within the deposition zone. It is common to observe the build-up of an amorphous, soft yellow film in the front zone.

Tube cleaning was attempted using the power supply 42 to inductively apply 400 to 500 watts of RF power to the coil 41, and using the inlet manifold 13 and pressure regulating valve 14 to inlet an etching gas comprising approximately four to seventeen percent by volume oxygen and the rest substantially $CF_4$ into the tube at a flow rate of 1 to 5 sccpm (standard cubic centimeters per minute) as measured by the flow meter 16. (This gas is available from LFE Corporation, 1601 Trapelo Road, Waltham, Massachusetts under the trade name DE-100). The vacuum pump maintained an internal tube pressure of 100 to 150 microns as measured by the vacuum gauge 19.

After etching for one hour, the yellowish, amorphous deposit was completely removed from the front zone 53, resulting in the clear transparent appearance that is characteristic of fused quartz. In the hotter deposition zone where the deposited silicon nitride was more dense and more etch-resistant, a semi-transparent gold film remained, indicating that the silicon nitride was not completely removed.

Example 2

A furnace tube 11 was cleaned using the above-described, conventional wet etch bath technique, then the tube was inserted in the furnace and about twenty five 500 Angstroms silicon nitride deposition cycles were performed using the process of Example 1.

To demonstrate removal of the deposit in the front zone using low RF power, the $CF_4$—$O_2$ etching gas of Example 1 was inlet at 50 sccpm and at 200 microns pressure, using only 100 watts of RF power. After a 20 minute etch, the quartz wall in the front zone 53 was translucent, indicating the deposited film had been completely removed.

Then, to demonstrate that cleaning action was occurring outside the front zone, i.e., downstream relative to the coil, a silicon wafer having a 444 Angstrom (.0444 micron) thick silicon nitride film thereon was placed at the center of the deposition zone. The 100 watts of power, 50 sccpm etchant gas flow rate, and 200 micron pressure parameters were again applied, with the result that approximately 35 Angstroms (.0035 microns) of the silicon nitride film were removed in two minutes.

Example 3

Again, numerous 500 Angstrom silicon nitride deposition cycles were performed prior to cleaning the tube. Then, a cleaning cycle was initiated, using a $CF_4$—$O_2$ etching gas flow rate of 1 to 2 sccpm to reduce the pressure to 100 microns and to extend the etching plasma more effectively into the deposition zone 52. RF power was set at 600 watts. After twenty minutes of etching, the tube was opened and initial inspection indicated that the front zone 53 was completely clean.

Etching was continued, this time using an increased gas flow rate of about 6 sccpm, which resulted in a pressure of 140 microns of mercury. The RF power was 400 watts. The etch time was 15 minutes. Visual inspection of the deposition zone indicated that this zone was much cleaner than before, although there appeared to be a slight residue.

Despite the visual suggestion of a silicon nitride residue, when the furnace tube was used for depositing silicon nitride as described in Example 1, the deposition rate was 19 Angstroms (.0019 micron) per minute. This is characteristic of the very clean state resulting from the use of the 1:1 HF:$HNO_3$ wet bath cleaning process. This deposition rate was taken as evidence that the 400 watt-11 sccpm flow rate-100 microns pressure etch parameters had in fact produced a plasma which cleaned the deposition zone 52.

Example 4

Two silicon wafers were first coated with a silicon nitride film. The film thickness was 644 Angstroms (.0644 micron) and 498 Angstroms (.0498 micron) for wafer No. 1 and wafer No. 2, respectively. The wafers were positioned 25 centimeters apart on a boat which was centered in the deposition zone with the wafers perpendicular to the longitudinal axis of the tube (perpendicular to the direction of flow of the reactants). The wafers were etched for 15 minutes using the $CF_4$—$O_2$ etching gas at a flow rate of about 6 sccpm, a pressure of 140 microns, and power of 400 watts. This etch removed about 266 Angstroms (.0266 micron) and 180 Angstroms (.018 micron) of silicon nitride from the first and second wafers, leaving a remaining thickness of 378 Angstroms (.0378 micron) and 311 Angstroms (.0311 micron), respectively. For the 15 minute etch, the average etch rate was thus 18 Angstroms (.0018 micron) per minute for wafer No. 1 (which was located nearer the RF coil 41), and 12 Angstroms (.0012 micron) per minute for wafer No. 2.

The above examples illustrate the following. First, plasma etch techniques can be applied to clean deposits such as silicon nitride from large reactor furnace tubes in situ without removing the tube from the furnace. Secondly, a wide range of power, flow rate, and pressure parameters can be applied not only to clean the tube in the vicinity of the coil, but also, by using an RF element spanning the length of the tube (as shown in Fig. 1), to clean along the entire length of the tube. Third, by reducing the etchant gas flow rate and/or the interior tube pressure and/or adjusting power, the etching can be extended downstream a considerable distance.

Other types of deposits and layers will be readily removed using the process of this invention. For example, silicon, silicon oxide, tantalum, tantalum nitride and molybdenum are rapidly or moderately etched by $CF_4$—$O_2$ etching gas. Furthermore, films and layers of these materials, such as films formed on wafers, can be etched, thus presenting the capability of depositing films, etching the films, and cleaning tube deposits in the same furnace system with minimum handling of the furnace tube. For example, a film such as silicon, silicon oxide or silicon nitride could be deposited on wafers positioned in the tube 11 within the furnace system, then the wafers would be removed from the tube and masked, and the masked wafers would be reinserted in the tube for simultaneously etching the films and cleaning tube deposits.

Examples 2—4 demonstrate the ability to extend the effective etching range by varying the etch parameters. Also, Examples 2—4 demonstrate that an RF element spanning about 25 centimeters of the front zone 53 (the front 89 centimeters of the tube) can be used not only to clean the entire front zone, but also to clean the middle, deposition zone 52. Based upon the lower, 12 Angstrom per minute etch rate (0.0012 microns per minute) of Example 4, the 12,000 Angstrom (1.2 micron) deposit would be completely removed from the deposition zone 52 in about 17 hours. This demonstrates that a coil covering no more than 25 centimeters of the front zone 53 can clean more than two-thirds of the tube within this time span. Also, this demonstrates that a coil covering no more than the front two-thirds of the tube could clean the entire tube. Furthermore, it is believed the 17 hour cleaning time could be considerably shortened. As the cleaning is in situ and doesn't require disassembly or reassembly of the tube, or drying the tube after the wet etch, the plasma etch could be performed overnight without taking the tube out of production use.

Furthermore, it is though that the 12 Angstroms per minute each rate is a very conservative estimate of the rates that can be readily achieved. Also, minimal additional experimentation with the etch parameters, including the etching gas composition, should increase the cleaning capability so that the effective cleaning plasma length is extended and the rate of etch is increased. It is the inventor's thought that it should be readily possible to clean the entire tube 11 in a matter of a few hours using an element which spans the front one-third or at most the front one-half of the tube.

The apparatus of Figs. 1—5 would be useful in a portable RF plasma cleaning. For example, the capacitive plates 33 could be formed on the tube 11, or formed as a separate unit which is attached to the tube 11, or could be a separate unit which is permanently attached to the furnace. A portable RF power source would supply power. A vacuum source would be used to provide pressures or perhaps 0.1 to 1 torr to institute a cleaning procedure for several hours or overnight. At the end of the cleaning, the portable RF source would be disconnected from the plates and, perhaps, moved to another furnace for another cleaning cycle.

Other alternative embodiments of the plasma etching apparatus of Figs. 1—5 will be readily attained by those skilled in the art. For example, instead of using a single coil, separate RF coupling elements may be placed along the front and rear zones of the tube and the etch parameters controlled so that the effective etching extends between the elements and along the length of the tube.

## Claims

1. A process for cleaning wall deposits from a furnace tube (11) used in a film deposition furnace system, the tube (11) having a gas inlet end (26) and a gas exit end (27), characterized by cleaning the tube (11) in situ in the furnace, comprising:
   maintaining the tube interior at subatmospheric pressure;
   supplying gas to the gas inlet end (26) of the tube (11), the gas being suitable for creating a deposit-etching plasma;
   generating RF energy; and
   applying the RF energy to RF element means (32, 33, 39, 41) located along a selected portion of the tube (11) adjacent the gas inlet end (26) for coupling the RF energy to the gas to form a deposit-etching plasma over at least the selected portion of the tube (11).

2. The process of claim 1 wherein at least a film on a substrate positioned within the tube (11) is etched simultaneously with the wall deposits.

3. The process of claim 1 wherein the RF element means (32, 33) spans essentially the length of the tube (11) for generating a deposit-etching plasma along the length of the tube (11).

4. The process of claim 1, wherein the tube is approximately 229 centimeters long and 12.5 centimeters in diameter and wherein the gas is oxygen and carbon tetrafluoromethane, and wherein the plasma is generated using a gas flow rate of from about 1 to 50 sccpm, 100 to 600 watts RF power, and a subatmospheric pressure of 100 to 200 microns of mercury.

5. The process of claim 1 wherein the plasma is extended downstream of the RF element means (39, 41) by controlling one or more of the flow rate of the reactant gases, the interior tube pressure, and the RF power.

6. The process of claim 1, 2, or 3 wherein the RF element means is selected from a coil (32) or a pair of capacitor plates (33).

7. The process of claim 1 or 5, further comprising applying an electric field within the tube (11) to facilitate forming the deposit-etching plasma.

8. The process of claim 5 wherein the tube is about 229 centimeters in length, the RF element means comprises first and second RF elements adjacent the front (26) and rear (27) ends of the tube (11), respectively, and wherein the plasma is extended between the first and second elements to encompass the tube length.

9. The process of claim 8 wherein each RF element is a coil (32) or a pair of capacitor plates (33).

10. The process of claim 1, or 4 wherein the RF element means (39, 41) extends over substantially less than the length of the tube (11) and a first pressure, a first gas flow rate, and a first RF power are applied to clean the tube (11) proximate the RF element, and wherein at least one of the pressure, gas flow, and RF power is changed to one of a second, lower pressure, a second, lower gas flow, or a second, higher RF power to extend the plasma toward the exit end (27) of the tube (11) to thereby extend the deposit-etching plasma along the tube (11).

11. The process of claim 1 or 4 wherein the RF element means (39, 41) spans less than about the front one-third of the tube (11) and the plasma is extended to encompass about two-thirds of the length of the tube (11).

12. The process of claim 1 or 5 wherein the deposit results from the deposition of silicon nitride, silicon oxide, or silicon.

13. The process of claim 10 wherein the deposit results from the deposition of silicon nitride and the first and second pressures, the first and second gas flow rates, and the first and second RF power are selected from the ranges 100 to 200 microns of mercury, 1 to 50 sccpm, and 100 to 600 watts, respectively.

14. An apparatus for cleaning wall deposits from a furnace tube (11) in situ within a film deposition furnace system, which comprises:

an RF element (32, 33) provided along a selected length of the furnace tube (11) adjacent an inlet end (26) of the tube (11);

means (31, 34, 36, 38, 42) for supplying RF energy to the RF element (32, 33);

pressure means comprising a vacuum pump connected to the exhaust manifold (21) of the tube (11) for creating subatmospheric pressure within the tube (11) to clean the wall deposit from at least the selected length; and

means for supplying reactant gases to the inlet end (26) of the furnace tube (11) for creating a deposit-etching plasma.

15. The apparatus of claim 14, wherein the RF element is selected from a coil (32) and a pair of capacitive plates (33).

16. The apparatus of claim 14 or 15 wherein the RF element (32, 33) spans essentially the length of the furnace tube (11).

17. The apparatus of claim 14, 15 or 16, further comprising an electrode (57) within the furnace tube (11) for applying an electrical field within the tube (11).

18. The apparatus of claim 14 or 15, further comprising a second RF element, the first and second RF elements being located at opposite ends (26, 27) of the furnace tube (11).

19. The apparatus of claim 14 or 15 wherein the apparatus includes means (24) for heating the furnce tube (11) and wherein the RF energy supply means (36, 37) is connected to the furnace heating means (24) for coupling RF energy to the tube (11).

20. The apparatus of claim 18 or 19, further comprising an electrical conductor (57) within the furnace tube (11) for applying an electrical field within the tube (11).

**Patentansprüche**

1. Verfahren zum Entfernen von Wandablagerungen von einer in einem Film-ablagerungs-Ofensystem verwendeten Ofen-röhre (11), die ein Gas-Einlassende (26) und ein Gas-Auslassende (27) besitzt, gekennzeichnet durch Reinigen der Röhre (11) an Ort und Stelle in dem Ofen unter Aufrechterhalten eines subatmosphärischen Druckes im Inneren der Röhre; Zuführen von Gas zu dem Gas-Einlassende (26) der Röhre (11), wobei das Gas ein Ablagerungs-Ätz-Plasma erzeugen kann; Erzeugen von Hochfrequenz- (RF) Energie; und Anlegen der Hochfrequenzenergie an Hochfrequenz-Elementmittel (32, 33, 39, 41), welche längs eines ausgewählten Teiles der Röhre (11) nahe dem Gas-Einlassende (26) zum Einkoppeln der Hochfrequenzenergie in das Gas angeordnet sind, um ein Ablagerungs-Ätz-Plasma über zumindest den ausgewählten Teil der Röhre (11) zu bilden.

2. Verfahren nach Anspruch 1, bei dem zumindest ein auf einem innerhalb der Röhre (11) angeordneten Substrat vorhandener Film gleichzeitig mit den Wandablagerungen geätzt wird.

3. Verfahren nach Anspruch 1, bei dem die Hochfrequenz-Elementmittel (32, 33) sich im wesentlichen über die Länge der Röhre (11) zur Erzeugung eines Ablagerungs-Ätz-Plasmas längs der Länge der Röhre (11) erstrecken.

4. Verfahren nach Anspruch 1, bei dem die Röhre annähernd 229 cm lang ist und einen Durchmesser von 12,5 cm besitzt und bei dem das Gas Sauerstoff und Kohlenstofftetrafluormethan ist und bei dem das Plasma unter Ver-wendung einer Gasflussgeschwindigkeit zwi-schen etwa 1 und 50 sccpm, einer Hochfrequenzleistung von 100 bis 600 Watt und einem subatmosphärischen Druck zwischen 100 und 200 $\mu$ Meter Quecksilber erzeugt wird.

5. Verfahren nach Anspruch 1, bei dem das Plasma sich von den Hochfrequenz-Elementmittel (39, 41) unter Steuerung der Flussgeschwindigkeit des Reaktanzgases, der Röhreninnendruckes und/oder der Hochfrequenzleistung sich flussabwärts erstreckt.

6. Verfahren nach Anspruch 1, 2 oder 3, bei dem die Hochfrequenz-Elementmittel ausgewählt werden aus einer Spule (32) oder zwei Kondensatorplatten (33).

7. Verfahren nach Anspruch 1 oder 5, bei dem ferner ein elektrisches Feld innerhalb der Röhre (11) zur Erleichterung der Bildung des Ablagerungs-Ätz-Plasmas angelegt wird.

8. Verfahren nach Anspruch 5, bei dem die Röhre etwa 229 cm lang ist, die Hochfrequenz-Elementmittel aus einem ersten und einem zweiten Hochfrequenz-Element bestehen, die nahe dem Vorderende (26) bzw. dem hinteren Ende (27) der Röhre (11) angeordnet sind und bei dem sich das Plasma zwischen dem ersten und dem zweiten Element unter Umgreifen der Röhrenlänge erstreckt.

9. Verfahren nach Anspruch 8, bei dem jedes Hochfrequenz-element eine Spule (32) oder ein paar Kondensatorplatten (33) ist.

10. Verfahren nach Anspruch 1 oder 4, bei dem die Hochfrequenz-Elementmittel (39, 41) sich im wesentlichen über weniger als die Länge der Röhre (11) erstrecken und ein erster Druck, eine erste Gasfliessgeschwindigkeit und eine erste Hochfrequenzleistung zur Reinigung der Röhre (11) nahe dem Hochfrequenzelement angelegt werden und bei dem zumindest der Druck, der Gasfluss und/oder die Hochfrequenzleistung geändert wird in eine zweiten niedrigeren Druck, einen zweiten niedrigeren Gasfluss oder eine zweite höhere Hochfrequenzleistung, um das Plasma in Richtung des Ausgangsendes (27) der Röhre (11) zu erstrecken und hierdurch das Ablagerungs-Ätz-Plasma längs der Röhre (11) zu erstrecken.

11. Verfahren nach Anspruch 1 oder 4, bei dem die Hochfrequenz-Elementmittel (39, 41) weniger als etwa das vordere Drittel der Röhre (11) umspannen und das Plasma ausgedehnt wird um etwa 2/3 der Länge der Röhre (11) zu umfassen.

12. Verfahren nach Anspruch 1 oder 5, bei dem die Ablagerung von der Ablagerung von Siliciumnitrit, Siliciumoxyd oder Silicium herrührt.

13. Verfahren nach Anspruch 10, bei dem die Ablagerung von der Ablagerung von Siliciumnitrit herrührt und die ersten und zweiten Drucke, die ersten und zweiten Gasflussgeschwindigkeiten und die ersten und zweiten Hochfrequenzleistungen ausgewählt werden von den Bereichen 100 bis 200 $\mu$ Meter Quecksilber 1 bis 50 sccpm bzw. 100 bis 600 Watt.

14. Ein Gerät zum Entfernen von Wandablagerungen von einer Filmablagerungs-Ofenröhre (11) an Ort und Stelle innerhalb des Ofensystems, bestehend aus einem Hochfrequenzelement (32, 33), welches längs einer ausgewählten Länge der Ofenröhre (11) nahe einem Einlassende (26) der Röhre (11) angeordnet ist; Mitteln (31, 34, 36, 38, 42), zum Zuführren der Hochfrequenzenergie zum dem Hochfrequenzelement (32, 33); Druckmitteln mit einer Vakuumpumpe, die an einen Absaugverteiler (21) der Röhre (11) zur Erzeugung von subatmospharischen Druck innerhalb der Rohre (11) zur Entfernung der Wandablagerung von zumindest der gewählten Länge verbunden ist; und Mitteln zum Zuführen von Reaktanzgasen zu dem Einlassende (26) der Ofenröhre (11) zur Erzeugung eines Ablagerungs-Ätz-Plasmas.

15. Gerät nach Anspruch 14, bei dem das Hochfrequenzelement ausgewählt wird von einer Spule (32) und einem Paar von kapazitiven Platten (33).

16. Gerät nach Anspruch 14 oder 15, bei dem das Hochfrequenzelement (32, 33) im wesentlichen die Länge der Ofenröhre (11) umfasst.

17. Gerät nach Anspruch 14, 15 oder 16, ferner bestehend aus einer Elektrode (57) innerhalb der Ofenröhre (11) zum Anlegen eines elektrischen Feldes innerhalb der Röhre (11).

18. Gerät nach Anspruch 14 oder 15, ferner bestehend aus einem zweiten Hochfrequenzelement, wobei das erste und zweite Hochfrequenzelement an entgegengesetzten Enden (26, 27) der Ofenröhre (11) angeordnet ist.

19. Gerät nach Anspruch 14 oder 15, bei dem das Gerät Mittel (24) zum Erhitzen der Ofenröhre (11) einschliesst und bei dem die Hochfrequenzenergie-Versorgungsmittel (36, 37) mit den Ofenheizmitteln (24) zum Ankoppeln der Hochfrequenzenergie an die Röhre (11) verbunden sind.

20. Gerät nach Anspruch 18 oder 19, ferner bestehend aus einem elektrischen Leiter (57) innerhalb der Ofenröhre (11) zum Anlegen eines elektrischen Feldes innerhalb der Röhre (11).

**Revendications**

1. Procédé en vue d'éliminer les dépôts de la paroi d'un tube de four (11) utilisé dans un système de four pour le dépôt d'une pellicule, ce tube (11) comportant une extrémité d'entrée de gaz (26) et une extrémité de sortie de gaz (27), caractérisé en ce qu'on procède au nettoyage du tube (11) in situ dans le four en effectuant les étapes qui consistent à

maintenir l'intérieur du tube sous une pression inférieure à la pression atmosphérique;

acheminer, à l'extrémité d'entrée de gaz (26) du tube (11), un gaz approprié pour créer un plasma attaquant les dépôts;

engendrer une énergie à haute fréquence; et appliquer cette énergie à haute fréquence à des éléments à haute fréquence (32, 33, 39, 41) localisés le long d'une partie sélectionnée du tube (11) qui est adjacente à l'extrémité d'entrée de gaz (26) en vue d'assurer un couplage entre l'énergie à haute fréquence et le gaz pour créer un plasma d'attaque de dépôts au moins sur la partie sélectionnée du tube (11).

2. Procédé suivant la revendication 1, caractérisé en ce qu'au moins une pellicule formée sur un substrat localisé à l'intérieur du tube (11) est attaquée en même temps que les dépôts de la paroi.

3. Procédé suivant la revendication 1, caractérisé en ce que les éléments à haute fréquence (32, 33) couvrent essentiellement la longueur du tube (11) en vue d'engendrer un plasma d'attaque de dépôts sur la longueur de ce dernier.

4. Procédé suivant la revendication 1, caractérisé en ce que le tube a une longueur d'environ 229 cm et un diamètre d'environ 12,5 cm, le gaz est constitué d'oxygène et de tétrafluorure de carbone et le plasma est engendré en utilisant un débit de gaz d'environ 1 à 50 cm3/minute, une énergie à haute fréquence de 100 à 600 watts et une pression inférieure à la pression atmosphérique de 100 à 200 microns de mercure.

5. Procédé suivant la revendication 1, caractérisé en ce que le plasma est propagé en aval des éléments à haute fréquence (39, 41) en contrôlant un ou plusieurs des paramètres que constituent le débit des gaz réactifs, la pression régnant à l'intérieur du tube et l'énergie à haute fréquence.

6. Procédé suivant la revendication 1, 2 ou 3, caractérisé en ce que les éléments à haute fréquence sont constitués d'une bobine (32) ou d'une paire de plaques de condensateurs (33).

7. Procédé suivant la revendication 1 ou 5, caractérisé en ce qu'il comprend également l'étape qui consiste à appliquer un champ électrique à l'intérieur du tube (11) en vue de faciliter la formation d'un plasma attaquant les dépôts.

8. Procédé suivant la revendication 5, caractérisé en ce que le tube a une longueur d'environ 229 cm, les éléments à haute fréquence comprennent un premier et un deuxième élément à haute fréquence adjacents aux extrémités avant (26) et arrière (27) du tube (11) respectivement, et le plasma s'étend entre ces premier et deuxième éléments en vue d'envelopper la longueur du tube.

9. Procédé suivant la revendication 8, caractérisé en ce que chaque élément à haute fréquence est une bobine (32) ou une paire de plaques de condensateurs (33).

10. Procédé suivant la revendication 1 ou 4, caractérisé en ce que les éléments à haute fréquence (39, 41) s'étendent sur une distance sensiblement inférieure à la longueur du tube (11), une première pression, un premier débit de gaz et une première énergie à haute fréquence étant appliqués pour nettoyer le tube (11) à proximité de l'élément à haute fréquence, tandis qu'au moins un des paramètres que constituent la pression, le débit de gaz et l'énergie à haute fréquence, est converti en une seconde pression plus basse, en un second débit de gaz moins élevé ou en une seconde énergie à haute fréquence plus élevée afin de propager le plasma vers l'extrémité de sortie (27) du tube (11) et de répartir ainsi le plasma d'attaque de dépôts le long de ce dernier.

11. Procédé suivant la revendication 1 ou 4, caractérisé en ce que les éléments à haute fréquence (39, 41) couvrent une distance inférieure à peu près au tiers avant du tube (11), tandis que le plasma est propagé pour envelopper à peu près les deux tiers de la longueur de ce dernier.

12. Procédé suivant la revendication 1 ou 5, caractérisé en ce que le dépôt résulte de l'application de nitrure de silicium, d'oxyde de silicium ou de silicium.

13. Procédé suivant la revendication 10, caractérisé en ce que le dépôt résulte de l'application de nitrure de silicium, tandis que les première et seconde pressions, les premier et second débits de gaz, ainsi que les première et seconde énergies à haute fréquence sont sélectionnés dans les intervalles allant de 100 à 200 microns de mercure, de 1 à 50 cm3/minute et de 100 à 600 watts, respectivement.

14. Appareil en vue d'éliminer les dépôts de la paroi d'un tube de four (11) in situ à l'intérieur d'un système de four de dépôt d'une pellicule, caractérisé en ce qu'il comprend:

un élément à haute fréquence (32, 33) prévu sur une longueur sélectionnée du tube de four (11) qui est adjacente à une extrémité d'entrée (26) de ce dernier;

des éléments (31, 34, 36, 38, 42) destinés à fournir une énergie à haute fréquence à l'élément à haute fréquence (32, 33);

un élément à pression constitué d'une pompe à vide raccordée au collecteur d'échappement (21) du tube (11) en vue de créer, à l'intérieur de ce dernier, une pression inférieure à la pression atmosphérique destinée à éliminer les dépôts d'au moins la longueur sélectionnée de la paroi; et

un élément destiné à acheminer des gaz réactifs à l'extrémité d'entrée (26) du tube de four (11) en vue de créer un plasma attaquant les dépôts.

15. Appareil suivant la revendication 14, caractérisé en ce que l'élément à haute fréquence est constitué d'une bobine (32) ou d'une paire de plaques de condensateurs (33).

16. Appareil suivant la revendication 14 ou 15, caractérisé en ce que l'élément à haute fréquence (32, 33) couvre essentiellement la longueur du tube de four (11).

17. Appareil suivant la revendication 14, 15 ou 16, caractérisé en ce qu'il comprend également une électrode (57) montée à l'intérieur du tube de four (11) en vue d'y appliquer un champ électrique.

18. Appareil suivant la revendication 14 ou 15, caractérisé en ce qu'il comprend également un second élément à haute fréquence, les premier et second éléments à haute fréquence étant localisés aux extrémités opposées (26, 27) du tube de four (11).

19. Appareil suivant la revendication 14 ou 15, caractérisé en ce qu'il comprend un élément (24) destiné à chauffer le tube de four (11), les éléments d'alimentation d'énergie à haute fréquence (36, 37) étant raccordés à cet élément chauffant (24) en vue de coupler l'énergie à haute fréquence au tube (11).

20. Appareil suivant la revendication 18 ou 19, caractérisé en ce qu'il comprend également un conducteur électrique (57) monté à l'intérieur du tube (11) en vue d'y appliquer un champ électrique.

FIG. 1

**FIG. 2**

23 HEATING ELEMENT POWER SUPPLY

33

33   24

34 RF POWER SUPPLY

**FIG. 3**

23 HEATING ELEMENT POWER SUPPLY

37 MATCHING NETWORK   36 RF POWER SUPPLY

39

24

38 RF POWER SUPPLY

# FIG.4

REACTANTS

FLOW METER - 16

INLET MANIFOLD - 13

HEATING ELEMENT POWER SUPPLY — 23

PRESSURE REGULATING VALVE - 14

24

27

VALVE - 22

26

41

INLET UBE

18

TO VACUUM PUMP

17

12

EXHAUST MANIFOLD - 21

11

VACUUM GAUGE - 19

42

10

RF POWER SUPPLY

0 020 746

3

# FIG. 5